(19) Europäisches Patentamt / European Patent Office / Office européen des brevets

(11) **EP 4 481 794 A1**

(12) **EUROPEAN PATENT APPLICATION**
published in accordance with Art. 153(4) EPC

(43) Date of publication:
**25.12.2024 Bulletin 2024/52**

(21) Application number: **22927327.1**

(22) Date of filing: **13.12.2022**

(51) International Patent Classification (IPC):
**H01L 21/3065** (2006.01)

(52) Cooperative Patent Classification (CPC):
**H01L 21/3065**

(86) International application number:
**PCT/JP2022/045918**

(87) International publication number:
**WO 2023/157441 (24.08.2023 Gazette 2023/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.02.2022 JP 2022022023**

(71) Applicant: **Resonac Corporation
Tokyo 105-7325 (JP)**

(72) Inventor: **SUZUKI Atsushi
Tokyo 105-8518 (JP)**

(74) Representative: **Strehl Schübel-Hopf & Partner
Maximilianstrasse 54
80538 München (DE)**

(54) **ETCHING METHOD**

(57) There is provided an etching method in which particles are hardly generated, even when the etching method is a low-temperature etching method that is supposed to be able to keep the side etching rate low. The etching method includes an etching step of setting the temperature of a member to be etched (4) having an etching object containing silicon to 0°C or less, bringing an etching gas containing an etching compound into contact with the member to be etched (4), and etching the etching object, the etching compound being a compound having at least one type of atom among a fluorine atom, a hydrogen atom, and an oxygen atom in the molecule. The etching gas contains or does not contain metal impurities having at least one type of metal. When the etching gas contains the metal impurities, the total concentration of all types of the contained metals is 4000 ppb by mass or less.

FIG. 1

EP 4 481 794 A1

**Description**

Technical Field

The present invention relates to an etching method.

Background Art

When manufacturing semiconductor elements, wiring lines are formed on a wafer by plasma etching. As the miniaturization of the wiring lines has progressed, a demand for wiring lines having a line width of 20 nm or less has increased. Therefore, when minute particles having a diameter of 100 nm or less are generated and remain on the wafer in plasma etching, there is a risk that the minute particles short-circuit the wiring lines or become obstacles in the subsequent etching, deposition steps, or the like, resulting in the inability to form the wiring lines. As a result, regions where designed electrical characteristics are not obtained are generated in the wafer, leading to a decrease in the productivity of the semiconductor elements. Accordingly, it is preferable that particles are hardly generated in the plasma etching. As a plasma etching method in which particles are hardly generated, a high-temperature etching method, in which etching is performed at temperatures equal to or more than normal temperature, is known.
In the plasma etching used in the manufacture of the semiconductor elements, a low side etching rate has been required. More specifically, in etching of an opening part having a high aspect ratio, it is preferable that lateral etching of a layer to be etched (e.g., a silicon-containing layer) directly under a mask hardly occurs. In the high-temperature etching method, particles are hardly generated. However, it has not been able to be said that the high-temperature etching method has had a sufficiently low side etching rate. As a plasma etching method having a low side etching rate, a low-temperature etching method in which etching is performed at temperatures of 0°C or less is known (see PTL 1, for example).

Citation List

Patent Literature

PTL 1: JP 2019-153771 A

Summary of Invention

Technical Problem

However, the low-temperature etching method has had a low side etching rate, but has been likely to generate particles.
It is an object of the present invention to provide an etching method in which particles are hardly generated, even when the etching method is a low-temperature etching method that is supposed to be able to keep the side etching rate low.

Solution to Problem

To achieve the above-described object, one aspect of the present invention is as described in [1] to [12] below.

[1] An etching method including: an etching step of setting the temperature of a member to be etched having an etching object containing silicon to 0°C or less, bringing an etching gas containing an etching compound into contact with the member to be etched, and etching the etching object, the etching compound being a compound having at least one type of atom among a fluorine atom, a hydrogen atom, and an oxygen atom in the molecule, in which the etching gas contains or does not contain metal impurities having at least one type of metal, and, when the etching gas contains the metal impurities, the total concentration of all types of the contained metals is 4000 ppb by mass or less.
[2] The etching method according to [1], in which the total concentration of all types of the contained metals is 10 ppb by mass or more and 4000 ppb by mass or less.
[3] The etching method according to [1] or [2], in which the metal impurities have at least one type among alkaline metal, alkaline earth metal, chromium, manganese, iron, cobalt, nickel, copper, zinc, aluminum, and tin.
[4] The etching method according to [3], in which the alkaline metal is at least one type among lithium, sodium, and potassium, and the alkaline earth metal is at least one type of magnesium and calcium.
[5] The etching method according to any one of [1] to [4], in which the concentration of each of all types of the contained metals is 1 ppb by mass or more.

[6] The etching method according to any one of [1] to [5], in which the etching compound is at least one type among a compound having a fluorine atom in the molecule and not having a hydrogen atom and an oxygen atom in the molecule, a compound having a hydrogen atom in the molecule and not having a fluorine atom and an oxygen atom in the molecule, a compound having an oxygen atom in the molecule and not having a fluorine atom and a hydrogen atom in the molecule, a compound having a fluorine atom and a hydrogen atom in the molecule and not having an oxygen atom in the molecule, a compound having a fluorine atom and an oxygen atom in the molecule and not having a hydrogen atom in the molecule, and a compound having a hydrogen atom and an oxygen atom in the molecule and not having a fluorine atom in the molecule.

[7] The etching method according to [6], in which the compound having a fluorine atom in the molecule and not having a hydrogen atom and an oxygen atom in the molecule is at least one type among sulfur hexafluoride, nitrogen trifluoride, chlorine trifluoride, iodine heptafluoride, bromine pentafluoride, phosphorus trifluoride, trifluoroiodomethane, fluorine gas, chain saturated perfluorocarbons having 1 or more and 3 or less carbon atoms, unsaturated perfluorocarbons having 2 or more and 6 or less carbon atoms, cyclic perfluorocarbons having 3 or more and 6 or less carbon atoms, and halons having 1 or more and 3 or less carbon atoms.

[8] The etching method according to [6], in which the compound having a hydrogen atom in the molecule and not having a fluorine atom and an oxygen atom in the molecule is at least one type among bromomethane, dibromomethane, hydrogen gas, hydrogen sulfide, hydrogen chloride, hydrogen bromide, ammonia, alkanes having 1 or more and 3 or less carbon atoms, alkenes having 2 or more and 4 or less carbon atoms, and cyclic alkanes having 3 or more and 6 or less carbon atoms.

[9] The etching method according to [6], in which the compound having an oxygen atom in the molecule and not having a fluorine atom and a hydrogen atom in the molecule is at least one type among oxygen gas, carbon monoxide, carbon dioxide, carbonyl sulfide, and sulfur dioxide.

[10] The etching method according to [6], in which the compound having a fluorine atom and a hydrogen atom in the molecule and not have an oxygen atom in the molecule is at least one type among chain saturated hydrofluorocarbons having 1 or more and 4 or less carbon atoms, unsaturated hydrofluorocarbons having 2 or more and 6 or less carbon atoms, and cyclic hydrofluorocarbons having 3 or more and 6 or less carbon atoms, and hydrogen fluoride.

[11] The etching method according to [6], in which the compound having a fluorine atom and an oxygen atom in the molecule and not having a hydrogen atom in the molecule is at least one type among carbonyl fluoride, oxygen difluoride, trifluoromethyl hypofluoride, perfluoroethers having 2 or more and 4 or less carbon atoms, and perfluoroketones having 3 or more and 5 or less carbon atoms.

[12] The etching method according to [6], in which the compound having a hydrogen atom and an oxygen atom in the molecule and not having a fluorine atom in the molecule is at least one type among water, alcohols having 1 or more and 3 or less carbon atoms, ethers having 2 or more and 4 or less carbon atoms, and ketones having 3 or more and 5 or less carbon atoms.

Advantageous Effects of Invention

According to the present invention, even in the case of a low-temperature etching method that is supposed to be able to keep the side etching rate low, particles are hardly generated.

Brief Description of Drawings

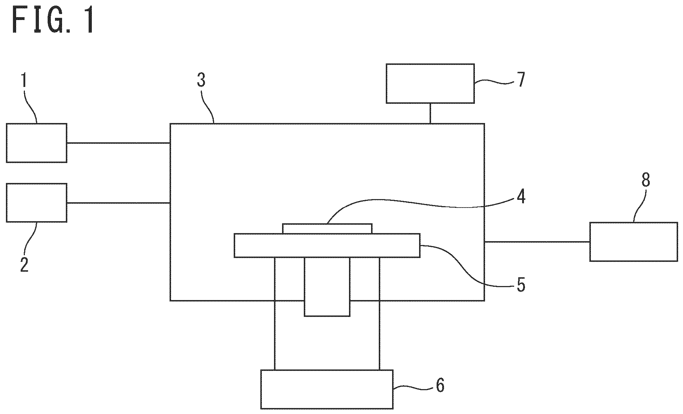

FIG. 1 is a schematic diagram of one example of an etching device for explaining one embodiment of an etching method according to the present invention.

Description of Embodiments

Hereinafter, one embodiment of the present invention is described. This embodiment describes one example of the present invention, and the present invention is not limited to this embodiment. This embodiment can be variously altered or improved, and such altered or improved aspects can also be included in the present invention.

An etching method according to this embodiment includes an etching step of setting the temperature of a member to be etched having an etching object containing silicon to 0°C or less, bringing an etching gas containing an etching compound into contact with the member to be etched, and etching the etching object, the etching compound being a compound having at least one type of atom among a fluorine atom, a hydrogen atom, and an oxygen atom in the molecule. The etching gas contains or does not contain metal impurities having at least one type of metal, and, when the etching gas contains the metal impurities, the total concentration of all types of the contained metals is 4000 ppb by mass or less.

When the etching gas containing the above-described etching compound is brought into contact with the member to be etched, the etching object containing silicon and the above-described etching compound in the etching gas react with each other, and therefore the etching of the etching object progresses. In contrast thereto, a non-etching object, such as a mask, hardly reacts with the above-described etching compound, and therefore the etching of the non-etching object hardly progresses. Accordingly, the etching method according to this embodiment can selectively etch the etching object over the non-etching object (i.e., high etching selectivity is obtained).

The etching method according to this embodiment is a low-temperature etching method in which etching is performed at temperatures of 0°C or less, and therefore etching can be performed at a lower side etching rate. Further, according to the etching method of this embodiment, the etching gas does not contain the metal impurities or, even when the etching gas contains the metal impurities, the amount is very small, and therefore particles are hardly generated in the etching.

Accordingly, the etching method according to this embodiment can be utilized for the manufacture of a semiconductor element. For example, when the etching method according to this embodiment is applied to a semiconductor substrate having a thin film containing a silicon compound and the thin film containing a silicon compound is etched, a semiconductor element can be manufactured. In the etching method according to this embodiment, particles, which cause a reduction in yield, are hardly generated, and therefore the productivity of the semiconductor element is high.

The number of the particles present on the surface of the member to be etched after the etching can be measured with a commercially available device. For example, the use of a Surfscan SP1 manufactured by KLA Tencor enables the detection of particles having a diameter of 50 nm or more. The number of the particles present on the surface of the member to be etched after the etching is preferably 0.5 particles/cm$^2$ or less, more preferably 0.1 particles/cm$^2$ or less, and still more preferably 0.05 particles/cm$^2$ or less.

The etching in the present invention refers to partially or entirely removing the etching object possessed by the member to be etched and processing the member to be etched into a specified shape (e.g., a three-dimensional shape) (e.g., processing a film-like etching object containing a silicon compound possessed by the member to be etched to have a predetermined film thickness). The "concentrations of metals" in the present invention are not the concentration of metal impurities but the concentrations of metals possessed by metal impurities. Further, the "metal" in the "concentrations of metals" in the present invention includes metal atoms and metal ions.

Hereinafter, the etching method according to this embodiment is described in more detail.

[Etching method]

For the etching method according to this embodiment, both plasma etching using a plasma or plasmaless etching using no plasma are usable. Examples of the plasma etching include reactive ion etching (RIE), inductively coupled plasma (ICP) etching, capacitively coupled plasma (CCP) etching, electron cyclotron resonance (ECR) plasma etching, and microwave plasma etching.

In the plasma etching, a plasma may be generated in a chamber where the member to be etched is placed or a plasma generating chamber and the chamber where the member to be etched is placed may be separated from each other (i.e., a remote plasma may be used). By etching using the remote plasma, the etching object containing silicon can be sometimes etched at a higher selectivity.

[Etching compound]

The etching compound contained in the etching gas is a compound that reacts with the etching object containing silicon to make etching of the etching object progress. The type of the etching compound is not particularly limited insofar as it is a compound having at least one type of atom among a fluorine atom, a hydrogen atom, and an oxygen atom in the molecule, and examples include the compounds below.

More specifically, examples of the etching compound include a compound having a fluorine atom in the molecule and not having a hydrogen atom and an oxygen atom in the molecule, a compound having a hydrogen atom in the molecule and not having a fluorine atom and an oxygen atom in the molecule, a compound having an oxygen atom in the molecule and not having a fluorine atom and a hydrogen atom in the molecule, a compound having a fluorine atom and a hydrogen atom in the molecule and not having an oxygen atom in the molecule, a compound having a fluorine atom and an oxygen atom in the molecule and not having a hydrogen atom in the molecule, a compound having a hydrogen atom and an oxygen atom in the molecule and not having a fluorine atom in the molecule, and a compound having a fluorine atom, a hydrogen atom, and an oxygen atom in the molecule.

Specific examples of the compound having a fluorine atom in the molecule and not having a hydrogen atom and an oxygen atom in the molecule include sulfur hexafluoride ($SF_6$), nitrogen trifluoride ($NF_3$), chlorine trifluoride ($ClF_3$), iodine heptafluoride ($IF_7$), bromine pentafluoride ($BrF_5$), phosphorus trifluoride ($PF_3$), trifluoroiodomethane ($CF_3I$), fluorine gas ($F_2$), chain saturated perfluorocarbons having 1 or more and 3 or less carbon atoms, unsaturated perfluorocarbons having 2 or more and 6 or less carbon atoms, cyclic perfluorocarbons having 3 or more and 6 or less carbon atoms, and halons having 1 or more and 3 or less carbon atoms.

Specific examples of the chain saturated perfluorocarbons having 1 or more and 3 or less carbon atoms include tetrafluoromethane ($CF_4$), hexafluoroethane ($C_2F_6$), and octafluoropropane ($C_3F_8$).

Specific examples of the unsaturated perfluorocarbons having 2 or more and 6 or less carbon atoms include tetrafluoroethylene ($C_2F_4$), hexafluoropropylene ($C_3F_6$), octafluoro-1-butene ($C_4F_8$), octafluoro-2-butene ($C_4F_8$), perfluoroisobutene ($C_4F_8$), hexafluorobutadiene ($C_4F_6$), hexafluoro-1-butyne ($C_4F_6$), hexafluoro-2-butyne ($C_4F_6$), decafluoro-1-pentene ($C_5F_{10}$), decafluoro-2-pentene ($C_5F_{10}$), perfluoro-2-methyl-2-butene ($C_5F_{10}$), octafluoro-1,4-pentadiene ($C_5F_8$), octafluoro-2,3-pentadiene ($C_5F_8$), octafluoro-1,3-pentadiene ($C_5F_8$), octafluoro-2-pentyne ($C_5F_8$), pentafluoro-3-trifluoromethyl-1-butyne ($C_5F_8$), decafluoro-1-hexene ($C_6F_{12}$), decafluoro-2-hexene ($C_6F_{12}$), decafluoro-3-hexene ($C_6F_{12}$), perfluoro-4-methyl-2-pentene ($C_6F_{12}$), perfluoro(2-methyl-2-pentene) ($C_6F_{12}$), perfluoro(2,3-dimethyl-2-butene) ($C_6F_{12}$), decafluoro-1,5-hexadiene ($C_6F_{10}$), decafluoro-2,4-hexadiene ($C_6F_{10}$), decafluoro-1,3-hexadiene ($C_6F_{10}$), decafluoro-1,4-hexadiene ($C_6F_{10}$), decafluoro-1-hexyne ($C_6F_{10}$), decafluoro-2-hexyne ($C_6F_{10}$), and decafluoro-3-hexyne ($C_6F_{10}$).

Specific example of the cyclic perfluorocarbons having 3 or more and 6 or less carbon atoms include hexafluorocyclopropane ($C_3F_6$), octafluorocyclobutane ($C_4F_8$), perfluorocyclobutene ($C_4F_6$), perfluorocyclopentene ($C_5F_8$), perfluorocyclopentane ($C_5F_{10}$), perfluoromethyl cyclobutane ($C_5F_{10}$), hexafluorobenzene ($C_6F_6$), perfluorocyclohexane ($C_6F_{12}$), perfluoromethyl cyclopentane ($C_6F_{12}$), perfluoro-1,2-dimethyl cyclobutane ($C_6F_{12}$), perfluoro-2,4-dimethyl cyclobutane ($C_6F_{12}$), perfluoro-3,4-dimethyl cyclobutane ($C_6F_{12}$), and perfluoro-4,4-dimethyl cyclobutane ($C_6F_{12}$).

Specific example of the halons having 1 or more and 3 or less carbon atoms include bromotrifluoromethane ($CBrF_3$), dibromodifluoromethane ($CBr_2F_2$), tribromofluoromethane ($CBr_3F$), bromopentafluoroethane ($C_2BrF_5$), dibromotetrafluoroethane ($C_2Br_2F_4$), tribromotrifluoroethane ($C_2Br_3F_3$), tetrabromodifluoroethane ($C_2Br_4F_2$), pentabromofluoroethane ($C_2Br_5F$), bromotrifluoroethylene ($C_2BrF_3$), dibromodifluoroethylene ($C_2Br_2F_2$), tribromofluoroethylene ($C_2Br_3F$), bromoheptafluoropropane ($C_3BrF_7$), dibromohexafluoropropane ($C_3Br_2F_6$), tribromopentafluoropropane ($C_3Br_3F_5$), tetrabromotetrafluoropropane ($C_3Br_4F_4$), pentabromotrifluoropropane ($C_3Br_5F_3$), hexabromodifluoropropane ($C_3Br_6F_2$), heptabromofluoropropane ($C_3Br_7F$), bromopentafluoropropene ($C_3BrF_5$), dibromotetrafluoropropene ($C_3Br_2F_4$), tribromotrifluoropropene ($C_3Br_3F_3$), tetrabromodifluoropropene ($C_3Br_4F_2$), pentabromofluoropropene ($C_3Br_5F$), bromopentafluorocyclopropane ($C_3BrF_5$), dibromotetrafluorocyclopropane ($C_3Br_2F_4$), tribromotrifluorocyclopropane ($C_3Br_3F_3$), tetrabromodifluorocyclopropane ($C_3Br_4F_2$), pentabromofluorocyclopropane ($C_3Br_5F$), bromotrifluorocyclopropene ($C_3BrF_3$), dibromodifluorocyclopropene ($C_3Br_2F_2$), and tribromofluorocyclopropene ($C_3Br_3F$).

In general, the halons refer to those having bromine atoms among halogenated hydrocarbons in which some or all of hydrogen atoms possessed by the hydrocarbons are substituted with halogen atoms, while, in the present invention, the halons refer to those having bromine atoms and fluorine atoms among halogenated hydrocarbons in which all of hydrogen atoms possessed by the hydrocarbons are substituted with halogen atoms.

Specific examples of the compound having a hydrogen atom in the molecule and not having a fluorine atom and an oxygen atom in the molecule include bromomethane ($CH_3Br$), dibromomethane ($CH_2Br_2$), hydrogen gas ($H_2$), hydrogen sulfide ($H_2S$), hydrogen chloride (HCl), hydrogen bromide (HBr), ammonia ($NH_3$), alkanes having 1 or more and 3 or less carbon atoms, alkenes having 2 or more and 4 or less carbon atoms, and cyclic alkanes having 3 or more and 6 or less carbon atoms.

Specific examples of the alkanes having 1 or more and 3 or less carbon atoms include methane ($CH_4$), ethane ($C_2H_6$), and propane ($C_3H_8$).

Specific examples of the alkenes having 2 or more and 4 or less carbon atoms include ethylene ($C_2H_4$), propylene ($C_3H_6$), 1-butene ($C_4H_8$), 2-butene ($C_4H_8$), and isobutene ($C_4H_8$).

Specific examples of the cyclic alkanes having 3 or more and 6 or less carbon atoms include cyclopropane ($C_3H_6$), cyclobutane ($C_4H_8$), cyclopentane ($C_5H_{10}$), and cyclohexane ($C_6H_{12}$).

The alkanes, alkenes, and cyclic alkanes above refer to those not having a fluorine atom and an oxygen atom in the molecules in the present invention.

Specific examples of the compound having an oxygen atom in the molecule and not having a fluorine atom and a hydrogen atom in the molecule include oxygen gas ($O_2$), ozone ($O_3$), carbon monoxide (CO), carbon dioxide ($CO_2$), carbonyl sulfide (COS), and sulfur dioxide ($SO_2$).

Specific examples of the compound having a fluorine atom and a hydrogen atom in the molecule and not having an oxygen atom in the molecule include chain saturated hydrofluorocarbons having 1 or more and 4 or less carbon atoms, unsaturated hydrofluorocarbons having 2 or more and 6 or less carbon atoms, cyclic hydrofluorocarbons having 3 or more and 6 or less carbon atoms, and hydrogen fluoride (HF).

Specific examples of the chain saturated hydrofluorocarbons having 1 or more and 4 or less carbon atoms include fluoromethane ($CH_3F$), difluoromethane ($CH_2F_2$), trifluoromethane ($CHF_3$), fluoroethane ($C_2H_5F$), difluoroethane ($C_2H_4F_2$), trifluoroethane ($C_2H_3F_3$), tetrafluoroethane ($C_2H_2F_4$), pentafluoroethane ($C_2HF_5$), fluoropropane ($C_3H_7F$), difluoropropane ($C_3H_6F_2$), trifluoropropane ($C_3H_5F_3$), tetrafluoropropane ($C_3H_4F_4$), pentafluoropropane ($C_3H_3F_5$), hexafluoropropane ($C_3H_2F_6$), heptafluoropropane ($C_3HF_7$), fluorobutane ($C_4H_9F$), difluorobutane ($C_4H_8F_2$), trifluorobutane ($C_4H_7F_3$), tetrafluorobutane ($C_4H_6F_4$), pentafluorobutane ($C_4H_5F_5$), hexafluorobutane ($C_4H_4F_6$), heptafluorobutane

($C_4H_3F_7$), octafluorobutane ($C_4H_2F_8$), nanofluorobutane ($C_4HF_9$), fluoromethyl propane ($C_4H_9F$), difluoromethyl propane ($C_4H_8F_2$), trifluoromethyl propane ($C_4H_7F_3$), tetrafluoromethyl propane ($C_4H_6F_4$), pentafluoromethyl propane ($C_4H_5F_5$), hexafluoromethyl propane ($C_4H_4F_6$), heptafluoromethyl propane ($C_4H_3F_7$), octafluoromethyl propane ($C_4H_2F_8$), and nanofluoromethyl propane ($C_4HF_9$).

Specific examples of the unsaturated hydrofluorocarbons having 2 or more and 6 or less carbon atoms include 2,3,3,3-tetrafluoropropene ($C_3H_2F_4$), 1,3,3,3-tetrafluoropropene ($C_3H_2F_4$), cis-1,1,1,4,4,4 hexafluoro-2-butene ($C_4H_2F_6$), and trans-1,1,1,4,4,4-hexafluoro-2-butene ($C_4H_2F_6$).

Specific example of the cyclic hydrofluorocarbons having 3 or more and 6 or less carbon atoms include fluorocyclopropane ($C_3H_5F$), difluorocyclopropane ($C_3H_4F_2$), trifluorocyclopropane ($C_3H_3F_3$), tetrafluorocyclopropane ($C_3H_2F_4$), pentafluorocyclopropane ($C_3HF_5$), fluorocyclobutane ($C_4H_7F$), difluorocyclobutane ($C_4H_6F_2$), trifluorocyclobutane ($C_4H_5F_3$), tetrafluorocyclobutane ($C_4H_4F_4$), pentafluorocyclobutane ($C_4H_3F_5$), hexafluorocyclobutane ($C_4H_2F_6$), heptafluorocyclobutane ($C_4HF_7$), fluoromethyl cyclopropane ($C_4H_7F$), difluoromethyl cyclopropane ($C_4H_6F_2$), trifluoromethyl cyclopropane ($C_4H_5F_3$), tetrafluoromethyl cyclopropane ($C_4H_4F_4$), pentafluoromethyl cyclopropane ($C_4H_3F_5$), hexafluoromethyl cyclopropane ($C_4H_2F_6$), heptafluoromethyl cyclopropane ($C_4HF_7$), fluorocyclopentane ($C_5H_9F$), difluorocyclopentane ($C_5H_8F_2$), trifluorocyclopentane ($C_5H_7F_3$), tetrafluorocyclopentane ($C_5H_6F_4$), pentafluorocyclopentane ($C_5H_5F_5$), hexafluorocyclopentane ($C_5H_4F_6$), heptafluorocyclopentane ($C_5H_3F_7$), octafluorocyclopentane ($C_5H_2F_8$), nanofluorocyclopentane ($C_5HF_9$), fluoromethyl cyclobutane ($C_5H_9F$), difluoromethyl cyclobutane ($C_5H_8F_2$), trifluoromethyl cyclobutane ($C_5H_7F_3$), tetrafluoromethyl cyclobutane ($C_5H_6F_4$), pentafluoromethyl cyclobutane ($C_5H_5F_5$), hexafluoromethyl cyclobutane ($C_5H_4F_6$), heptafluoromethyl cyclobutane ($C_5H_3F_7$), octafluoromethyl cyclobutane ($C_5H_2F_8$), nanofluoromethyl cyclobutane ($C_5HF_9$), fluorodimethyl cyclopropane ($C_5H_9F$), difluorodimethyl cyclopropane ($C_5H_8F_2$), trifluorodimethyl cyclopropane ($C_5H_7F_3$), tetrafluorodimethyl cyclopropane ($C_5H_6F_4$), pentafluorodimethyl cyclopropane ($C_5H_5F_5$), hexafluorodimethyl cyclopropane ($C_5H_4F_6$), heptafluorodimethyl cyclopropane ($C_5H_3F_7$), octafluorodimethyl cyclopropane ($C_5H_2F_8$), nanofluorodimethyl cyclopropane ($C_5HF_9$), fluoroethyl cyclopropane ($C_5H_9F$), difluoroethyl cyclopropane ($C_5H_8F_2$), trifluoroethyl cyclopropane ($C_5H_7F_3$), tetrafluoroethyl cyclopropane ($C_5H_6F_4$), pentafluoroethyl cyclopropane ($C_5H_5F_5$), hexafluoroethyl cyclopropane ($C_5H_4F_6$), heptafluoroethyl cyclopropane ($C_5H_3F_7$), octafluoroethyl cyclopropane ($C_5H_2F_8$), nanofluoroethyl cyclopropane ($C_5HF_9$), fluorocyclohexane ($C_6H_{11}F$), difluorocyclohexane ($C_6H_{10}F_2$), trifluorocyclohexane ($C_6H_9F_3$), tetrafluorocyclohexane ($C_6H_8F_4$), pentafluorocyclohexane ($C_6H_7F_5$), hexafluorocyclohexane ($C_6H_6F_6$), heptafluorocyclohexane ($C_6H_5F_7$), octafluorocyclohexane ($C_6H_4F_8$), nanofluorocyclohexane ($C_6H_3F_9$), decafluorocyclohexane ($C_6H_2F_{10}$), and undecafluorocyclohexane ($C_6HF_{11}$).

In the present invention, the hydrofluorocarbons refer to compounds in which some of hydrogen atoms possessed by the hydrocarbons are substituted with fluorine atoms.

Specific examples of the compound having a fluorine atom and an oxygen atom in the molecule and not having a hydrogen atom in the molecule include carbonyl fluoride ($COF_2$), oxygen difluoride ($OF_2$), trifluoromethyl hypofluoride ($CF_3OF$), perfluoroethers having 2 or more and 4 or less carbon atoms, and perfluoroketones having 3 or more and 5 or less carbon atoms.

Specific examples of the perfluoroethers having 2 or more and 4 or less carbon atoms include perfluorodimethyl ether ($CF_3OCF_3$), perfluoromethyl ethyl ether ($CF_3OC_2F_5$), perfluorodiethyl ether ($C_2F_5OC_2F_5$), and perfluoromethyl propyl ether ($CF_3OC_3F_7$).

Specific examples of the perfluoroketones having 3 or more and 5 or less carbon atoms include perfluoroacetone ($CF_3COCF_3$), perfluorobutanone ($CF_3COC_2F_5$), and perfluoropentanone ($CF_3COC_3F_7$, $C_2F_5COC_2F_5$).

In the present invention, the perfluoroethers refer to compounds in which all of hydrogen atoms of hydrocarbon groups possessed by the ethers are substituted with a fluorine atom, and the perfluoroketones refer to compounds in which all of hydrogen atoms of hydrocarbon groups possessed by the ketones are substituted with a fluorine atom.

Specific examples of the compound having a hydrogen atom and an oxygen atom in the molecule and not having a fluorine atom in the molecule include water ($H_2O$), alcohols having 1 or more and 3 or less carbon atoms, ethers having 2 or more and 4 or less carbon atoms, and ketones having 3 or more and 5 or less carbon atoms.

Specific examples of the alcohols having 1 or more and 3 or less carbon atoms include methanol ($CH_3OH$), ethanol ($C_2H_5OH$), propanol ($C_3H_7OH$), and isopropanol ($C_3H_7OH$).

Specific examples of the ethers having 2 or more and 4 or less carbon atoms include dimethyl ether ($CH_3OCH_3$), diethyl ether ($C_2H_5OC_2H_5$), methyl ethyl ether ($CH_3OC_2H_5$), and methyl propyl ether ($CH_3OC_3H_7$).

Specific examples of the ketones having 3 or more and 5 or less carbon atoms include acetone ($CH_3COCH_3$), butanone ($CH_3COC_2H_5$), and pentanone ($CH_3COC_3H_7$, $C_2H_5COC_2H_5$).

Specific examples of the compound having a fluorine atom, a hydrogen atom, and an oxygen atom in the molecule include hydrofluoroethers having 2 or more and 4 or less carbon atoms, fluoroalcohols having 2 or more and 4 or less carbon atoms, and hydrofluoroketones having 3 or more and 5 or less carbon atoms.

Specific examples of the hydrofluoroethers having 2 or more and 4 or less carbon atoms include pentafluorodimethyl ether ($CHF_2OCF_3$), tetrafluorodimethyl ether ($CHF_2OCHF_2$, $CH_2FOCF_3$), trifluorodimethyl ether ($CH_3OCF_3$, $CH_2FOCHF_2$), difluorodimethyl ether ($CH_3OCHF_2$, $CH_2FOCH_2F$), fluorodimethyl ether ($CH_3OCH_2F$), difluoromethyl

pentafluoroethyl ether ($CHF_2OC_2F_5$), trifluoromethyl tetrafluoroethyl ether ($CF_3OC_2HF_4$), fluoromethyl pentafluoroethyl ether ($CH_2FOC_2F_5$), difluoromethyl tetrafluoroethyl ether ($CHF_2OC_2HF_4$), trifluoromethyl trifluoroethyl ether ($CF_3OC_2H_2F_3$), methyl pentafluoroethyl ether ($CH_3OC_2F_5$), fluoromethyl tetrafluoroethyl ether ($CH_2FOC_2HF_4$), difluoromethyl trifluoroethyl ether ($CHF_2OC_2H_2F_3$), trifluoromethyl difluoroethyl ether ($CF_3OC_2H_3F_2$), methyl tetrafluoroethyl ether ($CH_3OC_2HF_4$), fluoromethyl trifluoroethyl ether ($CH_2FOC_2H_2F_3$), difluoromethyl difluoroethyl ether ($CHF_2OC_2H_3F_2$), trifluoromethyl fluoroethyl ether ($CF_3OC_2H_4F$), methyl trifluoroethyl ether ($CH_3OC_2H_2F_3$), fluoromethyl difluoroethyl ether ($CH_2FOC_2H_3F_2$), difluoromethyl fluoroethyl ether ($CHF_2OC_2H_4F$), trifluoromethyl ethyl ether ($CF_3OC_2H_5$), methyl difluoroethyl ether ($CH_3OC_2H_3F_2$), fluoromethyl fluoroethyl ether ($CH_2FOC_2H_4F$), difluoroethyl ether ($CHF_2OC_2H_5$), methyl fluoroethyl ether ($CH_3OC_2H_4F$), fluoromethyl ethyl ether ($CH_2FOC_2H_5$), tetrafluoroethyl pentafluoroethyl ether ($C_2HF_4OC_2F_5$), bistetrafluoroethyl ether ($C_2HF_4OC_2HF_4$), pentafluoroethyl trifluoroethyl ether ($C_2F_5OC_2H_2F_3$), pentafluoroethyl difluoroethyl ether ($C_2F_5OC_2H_3F_2$), tetrafluoroethyl trifluoroethyl ether ($C_2HF_4OC_2H_2F_3$), pentafluoroethyl fluoroethyl ether ($C_2F_5OC_2H_4F$), tetrafluoroethyl difluoroethyl ether ($C_2HF_4OC_2H_3F_2$), bistrifluoroethyl ether ($C_2H_2F_3OC_2H_2F_3$), ethyl pentafluoroethyl ether ($C_2H_5OC_2F_5$), fluoroethyl tetrafluoroethyl ether ($C_2H_4FOC_2HF_4$), difluoroethyl trifluoroethyl ether ($C_2H_3F_2OC_2H_2F_3$), ethyl tetrafluoroethyl ether ($C_2H_5OC_2HF_4$), fluoroethyl trifluoroethyl ether ($C_2H_4FOC_2H_2F_3$), bisdifluoroethyl ether ($C_2H_3F_2OC_2H_3F_2$), ethyl difluoroethyl ether ($C_2H_5OC_2H_3F_2$), bisfluoroethyl ether ($C_2H_4FOC_2H_4F$), ethyl fluoroethyl ether ($C_2H_5OC_2H_4F$), difluoromethyl heptafluoropropyl ether ($CHF_2OC_3F_7$), trifluoromethyl hexafluoropropyl ether ($CF_3OC_3HF_6$), fluoromethyl heptafluoropropyl ether ($CH_2FOC_3F_7$), difluoromethyl hexafluoropropyl ether ($CHF_2OC_3HF_6$), trifluoromethyl pentafluoropropyl ether ($CF_3OC_3H_2F_5$), methyl heptafluoropropyl ether ($CH_3OC_3F_7$), fluoromethyl hexafluoropropyl ether ($CH_2FOC_3HF_6$), difluoromethyl pentafluoropropyl ether ($CHF_2OC_3H_2F_5$), trifluoromethyl tetrafluoropropyl ether ($CF_3OC_3H_3F_4$), methyl hexafluoropropyl ether ($CH_3OC_3HF_6$), fluoromethyl pentafluoropropyl ether ($CH_2FOC_3H_2F_5$), difluoromethyl tetrafluoropropyl ether ($CHF_2OC_3H_3F_4$), trifluoromethyl trifluoropropyl ether ($CF_3OC_3H_4F_3$), methyl pentafluoropropyl ether ($CH_3OC_3H_2F_5$), fluoromethyl tetrafluoropropyl ether ($CH_2FOC_3H_3F_4$), difluoromethyl trifluoropropyl ether ($CHF_2OC_3H_4F_3$), trifluoromethyl difluoropropyl ether ($CF_3OC_3H_5F_2$), methyl tetrafluoropropyl ether ($CH_3OC_3H_3F_4$), fluoromethyl trifluoropropyl ether ($CH_2FOC_3H_4F_3$), difluoromethyl difluoropropyl ether ($CHF_2OC_3H_5F_2$), trifluoromethyl fluoropropyl ether ($CF_3OC_3H_6F$), methyl trifluoropropyl ether ($CH_3OC_3H_4F_3$), fluoromethyl difluoropropyl ether ($CH_2FOC_3H_2F_5$), difluoromethyl fluoropropyl ether ($CHF_2OC_3H_6F$), trifluoromethyl propyl ether ($CF_3OC_3H_7$), methyl difluoropropyl ether ($CH_3OC_3H_5F_2$), fluoromethyl fluoropropyl ether ($CH_2FOC_3H_6F$), difluoromethyl propyl ether ($CHF_2OC_3H_7$), methyl fluoropropyl ether ($CH_3OC_3H_6F$), and fluoromethyl propyl ether ($CH_2FOC_3H_7$).

Specific examples of the fluoroalcohols having 2 or more and 4 or less carbon atoms include trifluoroethanol ($CF_3CH_2OH$), hexafluoro-2-propanol ($CF_3CH(OH)CF_3$), pentafluoropropanol ($C_2F_5CH_2OH$), pentafluoro-2-propanol ($CF_3CH(OH)CHF_2$), tetrafluoropropanol ($C_2HF_4CH_2OH$), tetrafluoro-2-propanol ($CF_3CH(OH)CH_2F$, $CHF_2CH(OH)CHF_2$), trifluoropropanol ($C_2H_2F_3CH_2OH$), trifluoro-2-propanol ($CF_3CH(OH)CH_3$, $CHF_2CH(OH)CH_2F$), difluoropropanol ($C_2H_3F_2CH_2OH$), difluoro-2-propanol ($CHF_2CH(OH)CH_3$, $CH_2FCH(OH)CH_2F$), fluoropropanol ($C_2H_4FCH_2OH$), fluoro-2-propanol ($CH_2FCH(OH)CH_3$), and perfluoro-t-butanol ($CF_3C(CF_3)(OH)CF_3$).

Specific examples of the hydrofluoroketones having 3 or more and 5 or less carbon atoms include pentafluoroacetone ($CF_3COCHF_2$), tetrafluoroacetone ($CF_3COCH_2F$, $CHF_2COCHF_2$), trifluoroacetone ($CF_3COCH_3$, $CHF_2COCH_2F$), difluoroacetone ($CHF_2COCH_3$, $CH_2FCOCH_2F$), heptafluorobutanone ($C_2F_5COCHF_2$, $C_2HF_4COCF_3$), hexafluorobutanone ($C_2F_5COCH_2F$, $C_2HF_4COCHF_2$, $C_2H_2F_3COCH_3$), pentafluorobutanone ($C_2F_5COCH_3$, $C_2HF_4COCH_2F$, $C_2H_2F_3COCHF_2$, $C_2H_3F_2COCF_3$), tetrafluorobutanone ($C_2HF_4COCH_3$, $C_2H_2F_3COCH_2F$, $C_2H_3F_2COCHF_2$, $C_2H_4FCOCF_3$), trifluorobutanone ($C_2H_2F_3COCH_3$, $C_2H_3F_2COCH_2F$, $C_2H_4FCOCHF_2$, $C_2H_5COCF_3$), difluorobutanone ($C_2H_3F_2COCH_3$, $C_2H_4FCOCH_2F$, $C_2H_5COCHF_2$), fluorobutanone ($C_2H_4FCOCH_3$, $C_2H_5COCH_2F$), nonafluoro-3-pentanone ($C_2F_5COC_2HF_4$), octafluoro-3-pentanone ($C_2F_5COC_2H_2F_3$, $C_2HF_4COC_2HF_4$), heptafluoro-3-pentanone ($C_2F_5COC_2H_3F_2$, $C_2HF_4COC_2H_2F_3$), hexafluoro-3-pentanone ($C_2F_5COC_2H_4F$, $C_2HF_4COC_2H_3F_2$, $C_2H_2F_3COC_2H_2F_3$), pentafluoro-3-pentanone ($C_2F_5COC_2H_5$, $C_2HF_4COC_2H_4F$, $C_2H_2F_3COC_2H_3F_2$), tetrafluoro-3-pentanone ($C_2HF_4COC_2H_5$, $C_2H_2F_3COC_2H_4F$, $C_2H_3F_2COC_2H_3F_2$), trifluoro-3-pentanone ($C_2H_2F_3COC_2H_5$, $C_2H_3F_2COC_2H_4F$), difluoro-3-pentanone ($C_2H_3F_2COC_2H_5$, $C_2H_4FCOC_2H_4F$), fluoro-3-pentanone ($C_2H_4FCOC_2H_5$), nanofluoro-2-pentanone ($CHF_2COC_3F_7$, $CF_3COC_3HF_6$), octafluoro-2-pentanone ($CH_2FCOC_3F_7$, $CHF_2COC_3HF_6$, $CF_3COC_3H_2F_5$), heptafluoro-2-pentanone ($CH_3COC_3F_7$, $CH_2FCOC_3HF_6$, $CHF_2COC_3H_2F_5$, $CF_3COC_3H_3F_4$), hexafluoro-2-pentanone ($CH_3COC_3HF_6$, $CH_2FCOC_3H_2F_5$, $CHF_2COC_3H_3F_4$, $CF_3COC_3H_4F_3$), pentafluoro-2-pentanone ($CH_3COC_3H_2F_5$, $CH_2FCOC_3H_3F_4$, $CHF_2COC_3H_4F_3$, $CF_3COC_3H_5F_2$), tetrafluoro-2-pentanone ($CH_3COC_3H_3F_4$, $CH_2FCOC_3H_4F_3$, $CHF_2COC_3H_5F_2$, $CF_3COC_3H_6F$), trifluoro-2-pentanone ($CH_3COC_3H_4F_3$, $CH_2FCOC_3H_5F_2$, $CHF_2COC_3H_6F$, $CF_3COC_3H_7$), difluoro-2-pentanone ($CH_3COC_3H_5F_2$, $CH_2FCOC_3H_6F$, $CHF_2COC_3H_7$), and fluoro-2-pentanone ($CH_3COC_3H_6F$, $CH_2FCOC_3H_7$).

These etching compounds may be used alone or in combination of two or more types thereof.

[Etching gas]

The etching gas is gas containing the above-described etching compounds. The etching gas may be gas containing only the above-described etching compounds or may be mixed gas containing the above-described etching compounds and dilution gas. The etching gas may also be mixed gas containing the above-described etching compounds, dilution gas, and additive gas.

As the dilution gas, at least one type selected from nitrogen gas ($N_2$), helium (He), neon (Ne), argon (Ar), krypton (Kr), and xenon (Xe) is usable.

The content of the dilution gas is preferably 90% by volume or less and more preferably 50% by volume or less based on the total amount of the etching gas. The content of the dilution gas is preferably 10% by volume or more based on the total amount of the etching gas.

From the viewpoint of increasing the etching rate, the content of the etching compound in the etching gas is preferably 5% by volume or more and more preferably 10% by volume or more based on the total amount of the etching gas. From the viewpoint of reducing the usage amount of the etching compound, the content of the etching compound is preferably 90% by volume or less and more preferably 80% by volume or less based on the total amount of the etching gas.

The etching gas can be obtained by mixing a plurality of components (etching compound, dilution gas, and the like) constituting the etching gas. The mixing of the plurality of components may be performed either inside or outside a chamber. More specifically, the plurality of components constituting the etching gas each may be independently introduced into a chamber and mixed in the chamber or the plurality of components constituting the etching gas may be mixed to obtain the etching gas, and the obtained etching gas may be introduced into the chamber.

[Metal impurities]

The etching gas contains or does not contain metal impurities having at least one type of metal. When the metal impurities are contained, the total concentration of all types of metals contained in the etching gas is as low as 4000 ppb by mass or less, and therefore particles are hardly generated in etching as described above. The total concentration of all types of the contained metals is preferably 1000 ppb by mass or less and more preferably 100 ppb by mass or less.

When water is generated in etching, the water condenses on the surface of a member to be etched, which has reached 0°C or less. When the compound having a fluorine atom in the molecule is used as the etching compound, the contact of a hydrogen fluoride radical generated in etching with the water on the surface of the member to be etched generates hydrofluoric acid, and therefore etching by a chemical reaction is promoted, increasing the etching rate.

However, when the metal impurities are contained in the etching gas, there is a risk that particles are generated due to metal fluoride generated by a reaction between the metal impurities with hydrofluoric acid. The metal fluoride is chemically stable and has low volatility, and therefore is difficult to be removed by a dry process. Therefore, the metal fluoride can become an obstacle in the subsequent etching, deposition step, or the like. Therefore, the amount of the metal impurities contained in the etching gas is preferably smaller, and the total concentration of all types of metals contained in the etching gas needs to be 4000 ppb by mass or less.

The total concentration of all types of metals contained in the etching gas may be 10 ppb by mass or more. The concentration of each of all types of metals contained in the etching gas may be 1 ppb by mass or more.

The concentrations of the metals in the etching gas can be quantified with an inductively coupled plasma mass spectrometer (ICP-MS). Herein, not containing the metal impurities refers to a case where the quantification with the inductively coupled plasma mass spectrometer is impossible.

Metals possessed by the metal impurities include alkaline metals, alkaline earth metals, and metals belonging to Groups 3 to 14 of the periodic table (e.g., transition metals).

Examples of the alkaline metals include lithium (Li), sodium (Na), potassium (K), rubidium (Rb), cesium (Cs), and francium (Fr). Examples of the alkaline earth metals include beryllium (Be), magnesium (Mg), calcium (Ca), strontium (Sr), barium (Ba), and radium (Ra).

Examples of the metals belonging to Groups 3 to 14 of the periodic table include chromium (Cr), manganese (Mn), iron (Fe), cobalt (Co), nickel (Ni), copper (Cu), zinc (Zn), aluminum (Al), and tin (Sn).

The metals possessed by the metal impurities may be one type or two or more types of these metals.

The above-described metal impurities are sometimes contained in the etching gas as a metal simple substance, a metal compound, metal halide, or a metal complex. The forms of the metal impurities in the etching gas include fine particles, liquid droplets, gas, and the like. The above-described metal impurities are considered to be mixed into the etching gas through raw materials, a reactor, a purification device, a filling container, or the like used in the synthesis of the above-described etching compounds.

Methods for removing the above-described metal impurities from the above-described etching compounds include, for example, a method including passing the above-described etching compounds through a filter, a method including bringing the above-described etching compounds into contact with an adsorbent, or a method including separating the above-described etching compounds by distillation. Then, specifically, the above-described etching compounds are sealed in a stainless steel cylinder and the temperature is kept at a temperature equal to or less than the boiling points of the etching compounds under the internal pressure of the cylinder, for example, (e.g., in the case of tetrafluoromethane, the temperature is kept at -125°C under the internal pressure of the cylinder slightly higher than 1 atm), and a gas phase part is extracted using the method described in Examples described later or the like, and thus the etching gas with a reduced metal concentration can be obtained. The etching gas is preferably used for etching after the total concentration of the metals contained in the etching gas is reduced to 4000 ppb by mass or less by such a step of removing the metal impurities.

[Temperature condition of etching step]

The etching method according to this embodiment is a low-temperature etching method, and therefore etching is performed after the temperature of the member to be etched is set to 0°C or less. The temperature of the member to be etched is preferably set to -20°C or less and more preferably set to -40°C or less. When etching is performed after the temperature of the member to be etched is set within the range above, the etching can be performed at a lower side etching rate.

Herein, the temperature of the temperature condition is the temperature of the member to be etched, but the temperature of a stage, which is installed in a chamber of an etching device and supports the member to be etched, is also usable.

A bias power constituting a potential difference between a plasma generated when etching is performed and the member to be etched can be selected from 0 to 10000 W according to a desired etching shape. When etching is selectively performed, the bias power is preferably about 0 to 1000 W.

[Pressure condition of etching step]

The pressure condition of the etching step in the etching method according to this embodiment is not particularly limited, and is preferably set to 10 Pa or less and more preferably set to 5 Pa or less. When the pressure condition is within the range above, a plasma is likely to be stably generated. The pressure condition of the etching step is preferably 0.05 Pa or more. When the pressure condition is within the range above, a large number of ionization ions are generated and a sufficient plasma density is likely to be obtained.

The flow rate of the etching gas may be set as appropriate such that the pressure in a chamber is kept constant according to the volume of the chamber or the capacity of an exhaust facility of reducing the pressure in the chamber.

[Member to be etched]

The member to be etched that is etched by the etching method according to this embodiment has the etching object that is an object to be etched and may further contain a non-etching object that is not an object to be etched.

When the member to be etched has the etching object and the non-etching object, the member to be etched may be a member having a portion formed of the etching object and a portion formed of the non-etching object or may be a member formed of a mixture of the etching object and the non-etching object. The member to be etched may have things other than the etching object and the non-etching object.

The shape of the member to be etched is not particularly limited and may be a plate shape, a foil shape, a film shape, a powder shape, or a block shape, for example. Examples of the member to be etched include the above-described semiconductor substrate.

[Etching object]

The etching object may be formed of only materials containing silicon, may have a portion formed of only materials containing silicon and a portion formed of other materials, or may be formed of a mixture of materials containing silicon and other materials. Examples of the materials containing silicon include silicon oxide, silicon nitride, polysilicon, and silicon germanium (SiGe), for example. The materials containing silicon may be used alone or in combination of two or more types thereof.

Examples of silicon oxide include silicon dioxide ($SiO_2$). Silicon nitride refers to a compound having silicon and nitrogen in an optional ratio, and includes $Si_3N_4$, for example. The purity of silicon nitride is not particularly limited, and is preferably 30% by mass or more, more preferably 60% by mass or more, and still more preferably 90% by mass or more.

The shape of the etching object is not particularly limited and may be a plate shape, a foil shape, a film shape, a powder shape, or a block shape, for example. The etching object may or may not have shapes, such as patterns or holes, formed therein.

[Non-etching object]

The non-etching object does not substantially react with the above-described etching compounds or extremely slowly reacts with the above-described etching compounds. Therefore, even when etching is performed by the etching method according to this embodiment, the etching hardly progresses. The non-etching object is not particularly limited insofar as it has the above-described properties. Examples include a photoresist, amorphous carbon, titanium nitride, metals, such as copper, nickel, and cobalt, and oxides and nitrides of these metals. Among the above, a photoresist and amorphous carbon are more preferable from the viewpoint of ease of handling properties and availability.

The non-etching object is usable as a resist or a mask for suppressing the etching of the etching object by the etching gas. Thus, the etching method according to this embodiment can be utilized for a method including processing the etching object into a predetermined shape (e.g., processing the etching object in a film shape possessed by the member to be etched to have a predetermined film thickness), for example, utilizing the patterned non-etching object as the resist or the mask, and therefore is suitably usable for the manufacture of semiconductor elements. The non-etching object is hardly etched, and therefore etching of a portion that should not be essentially etched of a semiconductor element can be suppressed and the loss of the characteristics of a semiconductor element by etching can be prevented.

Next, one example of the configuration of an etching device capable of implementing the etching method according to this embodiment and one example of an etching method using the etching device are described with reference to FIG. 1. The etching device in FIG. 1 is a plasma etching device for performing etching using a plasma. First, the etching device in FIG. 1 is described.

The etching device in FIG. 1 includes a chamber 3 inside which etching is performed, a plasma generating device (not illustrated) generating a plasma into the chamber 3, a stage 5 supporting a member to be etched 4 that is etched inside the chamber 3, a cooling section 6 cooling the member to be etched 4 through the stage 5, a thermometer (not illustrated) measuring the temperature of the member to be etched 4, a vacuum pump 8 reducing the pressure inside the chamber 3, and a pressure gauge 7 measuring the pressure inside the chamber 3.

The type of a plasma generating mechanism of the plasma generating device is not particularly limited, and may be one applying a high-frequency voltage to parallel plates or one passing a high-frequency current through a coil. When a high-frequency voltage is applied to the member to be etched 4 in a plasma, a negative voltage is applied to the member to be etched 4, and positive ions are incident on the member to be etched 4 at high speed and perpendicularly, making anisotropic etching possible. In the etching device in FIG. 1, the stage 5 and a high frequency power supply of the plasma generating device are connected to each other, and a high frequency voltage can be applied to the stage 5.

The etching device in FIG. 1 includes an etching gas supply section supplying an etching gas to the chamber 3. The etching gas supply section has an etching compound gas supply section 1 supplying an etching compound gas, a dilution gas supply section 2 supplying dilution gas, a pipe connecting the etching compound gas supply section 1 and the chamber 3, and a pipe connecting the dilution gas supply section 2 and the chamber 3. A facility supplying additive gas may also be provided (not illustrated) in a form similar to that of the dilution gas supply section 2. The gas, such as the etching gas, supplied into the chamber 3 can be discharged out of the chamber 3 through an exhaust pipe, which is not illustrated.

When the etching compound gas is used as the etching gas, the etching compound gas may be supplied to the chamber 3 through a pipe by feeding out the etching compound gas from the etching compound gas supply section 1 after the inside of the chamber 3 is depressurized with the vacuum pump 8.

When a mixture of the etching compound gas and the dilution gas, such as inert gas, is used as the etching gas, the etching compound gas may be fed out from the etching compound gas supply section 1 and the dilution gas may be fed out from the dilution gas supply section 2 after the inside of the chamber 3 is depressurized with the vacuum pump 8. Thus, the etching compound gas and the dilution gas are mixed in the chamber 3 to form the etching gas.

The etching method according to this embodiment can be implemented using a common plasma etching device used in a semiconductor element manufacturing process, such as the etching device in FIG. 1, and the configurations of usable etching devices are not limited.

For example, the configuration of a temperature control mechanism of the chamber 3 may be a configuration in which the stage 5 is cooled from the outside of the chamber 3 with an external cooling section 6 as in the etching device in FIG. 1 or may be a configuration in which a cooling section cooling the stage 5 is provided directly on the stage 5 because the temperature of the member to be etched 4 only needs to be controlled to an optional temperature.

EXAMPLES

The present invention is more specifically described with reference to Examples and Comparative Examples below. Etching compound gases containing various concentrations of metal impurities were prepared. Preparation examples of the etching compound gases are described below.

(Preparation Example 1)

Three 1 L volume manganese steel cylinders (sealable cylindrical containers) were prepared. The cylinders are referred to as a cylinder A, a cylinder B, and a cylinder C in order. The cylinder A was filled with 300 g of tetrafluoromethane (boiling point at normal pressure: - 128°C). The tetrafluoromethane was liquefied by being cooled to -125°C, forming a liquid phase part and a gas phase part in an almost 100 kPa state. The cylinders B, C were cooled to -196°C after the inside was depressurized to 1 kPa or less with a vacuum pump.

200 g of tetrafluoromethane gas was extracted from an upper outlet, where the gas phase part is present, of the cylinder A, and transferred to the cylinder B in the depressurized state. 100 g of the tetrafluoromethane remaining in the cylinder A is set as Sample 1-1. Then, the tetrafluoromethane gas remaining in the cylinder A was extracted from the upper outlet, and the concentrations of various metals were measured with an inductively coupled plasma mass spectrometer according to the following method.

More specifically, while the tetrafluoromethane in a liquid phase in the cylinder A was being vaporized at 20°C, the tetrafluoromethane gas was extracted from the gas phase part, and distributed and brought into contact (bubbled) with 100 g of an aqueous nitric acid solution having a concentration of 1 mol/L at a flow rate of 100 mL/min for absorption of the metal impurities. The mass of the aqueous nitric acid solution having a concentration of 1 mol/L after the tetrafluoromethane gas was distributed was 80 g (M1). A mass difference in the cylinder A before and after the distribution of the tetrafluoromethane gas was 50 g (M2).

10 g (M3) of the aqueous nitric acid solution having a concentration of 1 mol/L was collected and diluted to 100 mL (V) with ultrapure water using a female flask. The concentrations of various metals in the aqueous solution thus prepared were measured with an inductively coupled plasma mass spectrometer, and the concentrations of the metals (C) in the tetrafluoromethane were calculated using a measured value (c1) and the following equation. The results are shown in Table 1.

$$C = \{(c1 \times V) \times (M1/M3)\}/M2$$

[Table 1]

| | Concentrations of alkaline metals | | | Concentrations of alkaline earth metals | | | Concentrations of chromium, manganese, iron, cobalt, nickel, copper, zinc, aluminum, tin | | | | | | | | | |
|---|---|---|---|---|---|---|---|---|---|---|---|---|---|---|---|---|
| | Li | Na | K | Mg | Ca | Total | Cr | Mn | Fe | Co | Ni | Cu | Zn | Al | Sn | Total |
| Sample 1-1 | 983 | 1205 | 1311 | 1004 | 1225 | 5828 | 1441 | 1286 | 1835 | 1637 | 1772 | 1635 | 1588 | 1535 | 1148 | 13877 |
| Sample 1-2 | 174 | 205 | 226 | 187 | 198 | 990 | 272 | 215 | 339 | 307 | 321 | 294 | 275 | 301 | 229 | 2553 |
| Sample 1-3 | 12 | 22 | 25 | 15 | 18 | 92 | 36 | 27 | 45 | 40 | 48 | 39 | 38 | 41 | 28 | 342 |

*) Unit of numerical values is ppb by mass.

Next, the temperature of the cylinder B was raised to -125°C, forming a liquid phase part and a gas phase part. 100 g of the tetrafluoromethane gas was extracted from an upper outlet, where the gas phase part was present, of the cylinder B and transferred to the cylinder C in the depressurized state. 100 g of the tetrafluoromethane remaining in the cylinder B is set as Sample 1-2. Then, the tetrafluoromethane gas remaining in the cylinder B was extracted from the upper outlet, and the concentrations of various metals were measured with an inductively coupled plasma mass spectrometer. The results are shown in Table 1.

Further, 100 g of the tetrafluoromethane in the cylinder C is set as Sample 1-3. The tetrafluoromethane gas was extracted from an upper outlet, where the gas phase part was present, of the cylinder C, and the concentrations of various metals were measured with an inductively coupled plasma mass spectrometer. The results are shown in Table 1.

(Preparation Example 2)

Samples 2-1, 2-2, 2-3 were prepared by performing the same operation as that in Preparation example 1, except that methane (boiling point at normal pressure: - 162°C) was used as the etching compound and the liquefaction temperature was set to -153°C. Then, the concentrations of various metals in each sample were measured with an inductively coupled plasma mass spectrometer in the same manner as in Preparation example 1 described above. The results are shown in Table 2.

[Table 2]

| | Concentrations of alkaline metals | | | Concentrations of alkaline earth metals | | | Concentrations of chromium, manganese, iron, cobalt, nickel, copper, zinc, aluminum, tin | | | | | | | | | |
|---|---|---|---|---|---|---|---|---|---|---|---|---|---|---|---|---|
| | Li | Na | K | Mg | Ca | Total | Cr | Mn | Fe | Co | Ni | Cu | Zn | Al | Sn | Total |
| Sample 2-1 | 953 | 1494 | 1355 | 1136 | 1039 | 5977 | 1522 | 1356 | 1754 | 1788 | 1811 | 1678 | 1622 | 1615 | 1200 | 14346 |
| Sample 2-2 | 145 | 249 | 212 | 183 | 161 | 950 | 257 | 225 | 293 | 288 | 308 | 274 | 263 | 268 | 199 | 2375 |
| Sample 2-3 | 11 | 24 | 21 | 13 | 18 | 87 | 37 | 34 | 46 | 44 | 44 | 34 | 37 | 39 | 23 | 338 |
| *) Unit of numerical values is ppb by mass. | | | | | | | | | | | | | | | | |

(Preparation example 3)

Samples 3-1, 3-2, 3-3 were prepared by performing the same operation as that in Preparation example 1, except that oxygen gas (boiling point at normal pressure: -183°C) was used as the etching compound and the liquefaction temperature was set to -153°C. Then, the concentrations of various metals in each sample were measured with an inductively coupled plasma mass spectrometer in the same manner as in Preparation example 1 described above. The results are shown in Table 3.

[Table 3]

| | Concentrations of alkaline metals | | | Concentrations of alkaline earth metals | | | Concentrations of chromium, manganese, iron, cobalt, nickel, copper, zinc, aluminum, tin | | | | | | | | | |
|---|---|---|---|---|---|---|---|---|---|---|---|---|---|---|---|---|
| | Li | Na | K | Mg | Ca | Total | Cr | Mn | Fe | Co | Ni | Cu | Zn | Al | Sn | Total |
| Sample 3-1 | 1025 | 1321 | 1333 | 984 | 991 | 5654 | 1511 | 1341 | 1653 | 1672 | 1733 | 1544 | 1601 | 1588 | 1203 | 13846 |
| Sample 3-2 | 173 | 227 | 221 | 162 | 161 | 944 | 248 | 215 | 266 | 267 | 288 | 243 | 268 | 257 | 199 | 2251 |
| Sample 3-3 | 18 | 21 | 25 | 16 | 15 | 95 | 32 | 29 | 36 | 34 | 40 | 33 | 37 | 35 | 24 | 300 |
| *) Unit of numerical values is ppb by mass. | | | | | | | | | | | | | | | | |

(Preparation example 4)

Samples 4-1, 4-2, 4-3 were prepared by performing the same operation as that in Preparation example 1, except that difluoromethane (boiling point at normal pressure: -52°C) was used as the etching compound and the liquefaction temperature was set to -50°C. Then, the concentrations of various metals in each sample were measured with an inductively coupled plasma mass spectrometer in the same manner as in Preparation example 1 described above. The results are shown in Table 4.

[Table 4]

| | Concentrations of alkaline metals | | | Concentrations of alkaline earth metals | | | Concentrations of chromium, manganese, iron, cobalt, nickel, copper, zinc, aluminum, tin | | | | | | | | | |
|---|---|---|---|---|---|---|---|---|---|---|---|---|---|---|---|---|
| | Li | Na | K | Mg | Ca | Total | Cr | Mn | Fe | Co | Ni | Cu | Zn | Al | Sn | Total |
| Sample 4-1 | 1201 | 1422 | 1391 | 1003 | 1043 | 6060 | 1665 | 1403 | 1788 | 1705 | 1738 | 1632 | 1612 | 1684 | 1122 | 14349 |
| Sample 4-2 | 199 | 212 | 208 | 143 | 155 | 917 | 278 | 238 | 298 | 282 | 287 | 272 | 267 | 270 | 177 | 2369 |
| Sample 4-3 | 18 | 17 | 19 | 13 | 14 | 81 | 38 | 34 | 45 | 42 | 41 | 36 | 37 | 35 | 26 | 334 |
| *) Unit of numerical values is ppb by mass. | | | | | | | | | | | | | | | | |

(Preparation example 5)

Samples 5-1, 5-2, 5-3 were prepared by performing the same operation as that in Preparation example 1, except that carbonyl fluoride (boiling point at normal pressure: -85°C) was used as the etching compound and the liquefaction temperature was set to -78°C. Then, the concentrations of various metals in each sample were measured with an inductively coupled plasma mass spectrometer in the same manner as in Preparation example 1 described above. The results are shown in Table 5.

[Table 5]

| | Concentrations of alkaline metals | | | Concentrations of alkaline earth metals | | | Concentrations of chromium, manganese, iron, cobalt, nickel, copper, zinc, aluminum, tin | | | | | | | | | |
|---|---|---|---|---|---|---|---|---|---|---|---|---|---|---|---|---|
| | Li | Na | K | Mg | Ca | Total | Cr | Mn | Fe | Co | Ni | Cu | Zn | Al | Sn | Total |
| Sample 5-1 | 1180 | 1225 | 1209 | 1018 | 984 | 5616 | 1522 | 1417 | 1603 | 1583 | 1591 | 1512 | 1567 | 1539 | 1233 | 13567 |
| Sample 5-2 | 171 | 175 | 177 | 148 | 147 | 818 | 214 | 204 | 229 | 221 | 223 | 215 | 222 | 218 | 176 | 1922 |
| Sample 5-3 | 15 | 16 | 15 | 14 | 12 | 72 | 31 | 29 | 37 | 30 | 31 | 29 | 32 | 31 | 24 | 274 |
| *) Unit of numerical values is ppb by mass. | | | | | | | | | | | | | | | | |

(Preparation example 6)

Samples 6-1, 6-2, 6-3 were prepared by performing the same operation as that in Preparation example 1, except that dimethyl ether (boiling point at normal pressure: -24°C) was used as the etching compound and the liquefaction temperature was set to -20°C. Then, the concentrations of various metals in each sample were measured with an inductively coupled plasma mass spectrometer in the same manner as in Preparation example 1 described above. The results are shown in Table 6.

[Table 6]

| | Concentrations of alkaline metals | | | Concentrations of alkaline earth metals | | | Concentrations of chromium, manganese, iron, cobalt, nickel, copper, zinc, aluminum, tin | | | | | | | | | |
|---|---|---|---|---|---|---|---|---|---|---|---|---|---|---|---|---|
| | Li | Na | K | Mg | Ca | Total | Cr | Mn | Fe | Co | Ni | Cu | Zn | Al | Sn | Total |
| Sample 6-1 | 1277 | 1402 | 1388 | 1317 | 1301 | 6685 | 1821 | 1743 | 1888 | 1739 | 1803 | 1758 | 1822 | 1792 | 1333 | 15699 |
| Sample 6-2 | 181 | 199 | 192 | 182 | 181 | 935 | 260 | 249 | 270 | 244 | 256 | 251 | 263 | 256 | 194 | 2243 |
| Sample 6-3 | 17 | 18 | 18 | 15 | 14 | 82 | 38 | 35 | 37 | 36 | 37 | 38 | 37 | 36 | 24 | 318 |

*) Unit of numerical values is ppb by mass.

(Example 1)

On the surface of a semiconductor wafer, a 1000 nm thick silicon oxide film and a 1000 nm thick silicon nitride film each were formed to be exposed to the surface without being stacked, and the resultant semiconductor wafer was set as a test piece. Then, the test piece was etched using an etching gas.

As the etching device, an ICP etching device RIE-230iP manufactured by Samco Inc., was used. Specifically, the etching gas was prepared by independently introducing each of the tetrafluoromethane of Sample 1-3 at a flow rate of 10 mL/min, the methane of Sample 2-3 at a flow rate of 5 mL/min, the oxygen gas of Sample 3-3 at a flow rate of 5 mL/min, and argon at a flow rate of 30 mL/min into a chamber and mixing them in the chamber. Then, the etching gas in the chamber was partially taken out, and the concentrations of various metals in the etching gas were measured with an inductively coupled plasma mass spectrometer. The results are shown in Table 7.

Next, a high-frequency voltage was applied at 500 W to convert the etching gas into a plasma in the chamber. Then, the test piece in the chamber was etched under etching conditions of a pressure of 3 Pa, a temperature of the test piece of -50°C, and a bias power of 100 W.

When the etching was completed, the temperature of the test piece was set to 20°C and argon was introduced into the chamber at a flow rate of 30 mL/min to purge the surface of the test piece. Thereafter, the test piece was taken out from the chamber, and the number of particles present on the surface of each of the silicon oxide film and the silicon nitride film was measured. The number of the particles was measured using a Surfscan SP1 manufactured by KLA Tencor. The results are shown in Table 7. As shown in Table 7, the number of the particles is 0.1 particles/cm$^2$ or less, and therefore the generation of the particles by etching is suppressed.

[Table 7]

| | Concentrations of metals (ppb by mass) | | | | | | | | | | | | | | | Number of particles (particles/cm²) | |
|---|---|---|---|---|---|---|---|---|---|---|---|---|---|---|---|---|---|
| | Li | Na | K | Mg | Ca | Cr | Mn | Fe | Co | Ni | Cu | Zn | Al | Sn | Total | Silicon oxide film | Silicon nitride film |
| Ex. 1 | 5 | 9 | 10 | 6 | 7 | 14 | 12 | 17 | 16 | 18 | 15 | 15 | 16 | 10 | 169 | 0.02 | 0.01 |
| Ex. 2 | 38 | 46 | 50 | 40 | 43 | 61 | 49 | 76 | 69 | 73 | 66 | 62 | 68 | 51 | 791 | 0.08 | 009 |
| Comp. Ex. 1 | 200 | 246 | 267 | 204 | 248 | 295 | 264 | 375 | 335 | 363 | 334 | 325 | 314 | 234 | 4003 | 1.3 | 1.1 |

(Example 2)

The test piece was etched by performing the same operation as that in Example 1, except that the tetrafluoromethane of Sample 1-2 was used in place of the tetrafluoromethane of Sample 1-3. The measurement results of the concentrations of the metals and the measurement results of the number of particles are shown in Table 7. As shown in Table 7, the number of the particles is 0.1 particles/cm$^2$ or less, and therefore the generation of the particles by etching is suppressed.

(Comparative Example 1)

The test piece was etched by performing the same operation as that in Example 1, except that the tetrafluoromethane of Sample 1-1 was used in place of the tetrafluoromethane of Sample 1-3. The measurement results of the concentrations of the metals and the measurement results of the number of particles are shown in Table 7. As shown in Table 7, the number of the particles is more than 0.5 particles/cm$^2$, and therefore the generation of the particles by etching is not suppressed.

(Example 3)

The test piece was etched by performing the same operation as that in Example 1, except that an etching gas was prepared by independently introducing each of the methane of Sample 2-3 at a flow rate of 10 mL/min, the tetrafluoromethane of Sample 1-3 at a flow rate of 5 mL/min, the oxygen gas of Sample 3-3 at a flow rate of 5 mL/min, and argon at a flow rate of 30 mL/min into a chamber and mixing them in the chamber.

When the etching was completed, the temperature of the test piece was set to 20°C and argon was introduced into the chamber at a flow rate of 30 mL/min to purge the surface of the test piece. After the purge was completed, the test piece was taken out from the chamber, and the number of particles was measured in the same manner as in Example 1. Table 8 shows the measurement results of the concentrations of the metals and the measurement results of the number of particles.

As shown in Table 8, the number of the particles is 0.1 particles/cm$^2$ or less, and therefore the generation of the particles by etching is suppressed.

[Table 8]

| | Concentrations of metals (ppb by mass) | | | | | | | | | | | | | | | Number of particles (particles/cm$^2$) | |
|---|---|---|---|---|---|---|---|---|---|---|---|---|---|---|---|---|---|
| | Li | Na | K | Mg | Ca | Cr | Mn | Fe | Co | Ni | Cu | Zn | Al | Sn | Total | Silicon oxide film | Silicon nitride film |
| Ex. 3 | 5 | 9 | 9 | 6 | 7 | 14 | 12 | 17 | 16 | 18 | 14 | 15 | 15 | 10 | 168 | 0.02 | 0.02 |
| Ex. 4 | 32 | 54 | 47 | 40 | 36 | 58 | 51 | 67 | 65 | 70 | 62 | 60 | 61 | 45 | 748 | 0.07 | 0.08 |
| Comp. Ex. 2 | 194 | 303 | 276 | 230 | 211 | 311 | 277 | 359 | 365 | 371 | 343 | 332 | 331 | 245 | 4148 | 11 | 12 |

(Example 4)

The test piece was etched and purged by performing the same operation as that in Example 3, except that the methane of Sample 2-2 was used in place of the methane of Sample 2-3. Table 8 shows the measurement results of the concentrations of the metals and the measurement results of the number of particles. As shown in Table 8, the number of the particles is 0.1 particles/cm$^2$ or less, and therefore the generation of the particles by etching is suppressed.

(Comparative Example 2)

The test piece was etched and purged by performing the same operation as that in Example 3, except that the methane of Sample 2-1 was used in place of the methane of Sample 2-3. Table 8 shows the measurement results of the concentrations of the metals and the measurement results of the number of particles. As shown in Table 8, the number of the particles is more than 0.5 particles/cm$^2$, and therefore the generation of the particles by etching is not suppressed.

(Example 5)

The test piece was etched and purged by performing the same operation as that in Example 3, except that an etching gas was prepared by independently introducing each of the oxygen gas of Sample 3-3 at a flow rate of 10 mL/min, the difluoromethane of Sample 4-3 at a flow rate of 10 mL/min, and argon at a flow rate of 30 mL/min into a chamber and mixing them in the chamber. Table 9 shows the measurement results of the concentrations of the metals and the measurement results of the number of particles. As shown in Table 9, the number of the particles is 0.1 particles/cm$^2$ or less, and therefore the generation of the particles by etching is suppressed.

[Table 9]

| | Concentrations of metals (ppb by mass) | | | | | | | | | | | | | | | Number of particles (particles/cm$^2$) | |
|---|---|---|---|---|---|---|---|---|---|---|---|---|---|---|---|---|---|
| | Li | Na | K | Mg | Ca | Cr | Mn | Fe | Co | Ni | Cu | Zn | Al | Sn | Total | Silicon oxide film | Silicon nitride film |
| Ex. 5 | 7 | 8 | 9 | 6 | 6 | 14 | 13 | 16 | 15 | 16 | 14 | 15 | 14 | 10 | 162 | 0.03 | 0.02 |
| Ex. 6 | 38 | 49 | 48 | 35 | 35 | 57 | 50 | 62 | 62 | 66 | 56 | 61 | 58 | 45 | 722 | 0.1 | 0.09 |
| Ex. 7 | 43 | 47 | 47 | 32 | 34 | 62 | 53 | 67 | 63 | 65 | 61 | 61 | 61 | 40 | 736 | 0.09 | 0.08 |
| Comp. Ex. 3 | 219 | 268 | 270 | 199 | 201 | 310 | 275 | 340 | 343 | 355 | 316 | 328 | 335 | 246 | 4004 | 1.5 | 12 |
| Comp. Ex. 4 | 244 | 289 | 283 | 204 | 212 | 339 | 286 | 365 | 348 | 356 | 333 | 330 | 344 | 229 | 4161 | 1.7 | 1.9 |

(Example 6)

The test piece was etched and purged by performing the same operation as that in Example 5, except that the oxygen gas of Sample 3-2 was used in place of the oxygen gas of Sample 3-3. Table 9 shows the measurement results of the concentrations of the metals and the measurement results of the number of particles. As shown in Table 9, the number of the particles is 0.1 particles/cm$^2$ or less, and therefore the generation of the particles by etching is suppressed.

(Example 7)

The test piece was etched and purged by performing the same operation as that in Example 5, except that the difluoromethane of Sample 4-2 was used in place of the difluoromethane of Sample 4-3. Table 9 shows the measurement results of the concentrations of the metals and the measurement results of the number of particles. As shown in Table 9, the number of the particles is 0.1 particles/cm$^2$ or less, and therefore the generation of the particles by etching is suppressed.

(Comparative Example 3)

The test piece was etched and purged by performing the same operation as that in Example 5, except that the oxygen gas of Sample 3-1 was used in place of the oxygen gas of Sample 3-3. Table 9 shows the measurement results of the concentrations of the metals and the measurement results of the number of particles. As shown in Table 9, the number of the particles is more than 0.5 particles/cm$^2$, and therefore the generation of the particles by etching is not suppressed.

(Comparative Example 4)

The test piece was etched and purged by performing the same operation as that in Example 5, except that the difluoromethane of Sample 4-1 was used in place of the difluoromethane of Sample 4-3. Table 9 shows the measurement results of the concentrations of the metals and the measurement results of the number of particles. As shown in Table 9, the number of the particles is more than 0.5 particles/cm$^2$, and therefore the generation of the particles by etching is not suppressed.

(Example 8)

The test piece was etched and purged by performing the same operation as that in Example 3, except that an etching gas was prepared by independently introducing each of the carbonyl fluoride of Sample 5-3 at a flow rate of 10 mL/min, the methane of Sample 2-3 at a flow rate of 10 mL/min, and argon at a flow rate of 30 mL/min into a chamber and mixing them in the chamber. Table 10 shows the measurement results of the concentrations of the metals and the measurement results of the number of particles. As shown in Table 10, the number of the particles is 0.1 particles/cm$^2$ or less, and therefore the generation of the particles by etching is suppressed.

[Table 10]

| | Concentrations of metals (ppb by mass) | | | | | | | | | | | | | | | Number of particles (particles/cm$^2$) | |
|---|---|---|---|---|---|---|---|---|---|---|---|---|---|---|---|---|---|
| | Li | Na | K | Mg | Ca | Cr | Mn | Fe | Co | Ni | Cu | Zn | Al | Sn | Total | Silicon oxide film | Silicon nitride film |
| Ex. 8 | 5 | 8 | 7 | 5 | 6 | 14 | 13 | 17 | 15 | 15 | 13 | 14 | 14 | 9 | 154 | 0.03 | 0.02 |
| Ex. 9 | 36 | 40 | 40 | 32 | 33 | 50 | 48 | 55 | 53 | 53 | 50 | 52 | 51 | 40 | 633 | 0.09 | 009 |
| Comp. Ex. 5 | 238 | 250 | 246 | 241 | 230 | 312 | 295 | 330 | 325 | 327 | 320 | 321 | 326 | 251 | 4012 | 1.8 | 1.5 |

(Example 9)

The test piece was etched and purged by performing the same operation as that in Example 8, except that the carbonyl fluoride of Sample 5-2 was used in place of the carbonyl fluoride of Sample 5-3. Table 10 shows the measurement results of the concentrations of the metals and the measurement results of the number of particles. As shown in Table 10, the number of the particles is 0.1 particles/$cm^2$ or less, and therefore the generation of the particles by etching is suppressed.

(Comparative Example 5)

The test piece was etched and purged by performing the same operation as that in Example 8, except that the carbonyl fluoride of Sample 5-1 was used in place of the carbonyl fluoride of Sample 5-3. Table 10 shows the measurement results of the concentrations of the metals and the measurement results of the number of particles. As shown in Table 10, the number of the particles is more than 0.5 particles/$cm^2$, and therefore the generation of the particles by etching is not suppressed.

(Example 10)

The test piece was etched and purged by performing the same operation as that in Example 3, except that an etching gas was prepared by independently introducing each of the dimethyl ether of Sample 6-3 at a flow rate of 10 mL/min, the tetrafluoromethane of Sample 1-3 at a flow rate of 10 mL/min, and argon at a flow rate of 30 mL/min into a chamber and mixing them in the chamber. Table 11 shows the measurement results of the concentrations of the metals and the measurement results of the number of particles. As shown in Table 11, the number of the particles is 0.1 particles/$cm^2$ or less, and therefore the generation of the particles by etching is suppressed.

[Table 11]

| | Concentrations of metals (ppb by mass) | | | | | | | | | | | | | | | Number of particles (particles/cm$^2$) | |
|---|---|---|---|---|---|---|---|---|---|---|---|---|---|---|---|---|---|
| | Li | Na | K | Mg | Ca | Cr | Mn | Fe | Co | Ni | Cu | Zn | Al | Sn | Total | Silicon oxide film | Silicon nitride film |
| Ex. 10 | 6 | 8 | 9 | 6 | 6 | 15 | 12 | 16 | 15 | 17 | 15 | 15 | 15 | 10 | 167 | 0.02 | 0.02 |
| Ex. 11 | 39 | 44 | 43 | 39 | 40 | 59 | 55 | 63 | 57 | 61 | 58 | 60 | 59 | 44 | 722 | 0.08 | 009 |
| Comp. Ex. 6 | 258 | 285 | 283 | 266 | 264 | 371 | 354 | 387 | 356 | 370 | 359 | 372 | 367 | 272 | 4564 | 1.3 | 1.4 |

(Example 11)

The test piece was etched and purged by performing the same operation as that in Example 10, except that the dimethyl ether of Sample 6-2 was used in place of the dimethyl ether of Sample 6-3. Table 11 shows the measurement results of the concentrations of the metals and the measurement results of the number of particles. As shown in Table 11, the number of the particles is 0.1 particles/cm$^2$ or less, and therefore the generation of the particles by etching is suppressed.

(Comparative Example 6)

The test piece was etched and purged by performing the same operation as that in Example 10, except that the dimethyl ether of Sample 6-1 was used in place of the dimethyl ether of Sample 6-3. Table 11 shows the measurement results of the concentrations of the metals and the measurement results of the number of particles. As shown in Table 11, the number of the particles is more than 0.5 particles/cm$^2$, and therefore the generation of the particles by etching is not suppressed.

(Example 12)

The test piece was etched by performing the same operation as that in Example 1, except that the temperature of the test piece was set to -5°C. The number of particles present on the surface of the silicon oxide film was 0.04 particles/cm$^2$ and the number of particles present on the surface of the silicon nitride film was 0.03 particles/cm$^2$, and the generation of particles by etching was suppressed.

(Comparative Example 7)

The test piece was etched by performing the same operation as that in Comparative Example 1, except that the temperature of the test piece was set to -5°C. The number of particles present on the surface of the silicon oxide film was 1.4 particles/cm$^2$ and the number of particles present on the surface of the silicon nitride film was 1.1 particles/cm$^2$, and the generation of particles by etching was not suppressed.

(Reference Example 1)

The test piece was etched by performing the same operation as that in Example 1, except that the temperature of the test piece was set to 25°C. The number of particles present on the surface of the silicon oxide film was 0.02 particles/cm$^2$ and the number of particles present on the surface of the silicon nitride film was 0.03 particles/cm$^2$, and the generation of particles by etching was suppressed.

(Reference Example 2)

The test piece was etched by performing the same operation as that in Comparative Example 1, except that the temperature of the test piece was set to 25°C. The number of particles present on the surface of the silicon oxide film was 0.07 particles/cm$^2$ and the number of particles present on the surface of the silicon nitride film was 0.05 particles/cm$^2$, and the generation of particles by etching was suppressed.

Reference Signs List

1    etching compound gas supply section
2    dilution gas supply section
3    chamber
4    member to be etched
5    stage
6    cooling section
7    pressure gauge
8    vacuum pump

Claims

1.  An etching method comprising:

    an etching step of setting a temperature of a member to be etched having an etching object containing silicon to 0°C or less, bringing an etching gas containing an etching compound into contact with the member to be etched, and etching the etching object,
    the etching compound being a compound having at least one type of atom among a fluorine atom, a hydrogen atom, and an oxygen atom in a molecule, wherein
    the etching gas contains or does not contain metal impurities having at least one type of metal, and, when the etching gas contains the metal impurities, a total concentration of all types of the contained metals is 4000 ppb by mass or less.

2.  The etching method according to claim 1, wherein the total concentration of all types of the contained metals is 10 ppb by mass or more and 4000 ppb by mass or less.

3.  The etching method according to claim 1 or 2, wherein the metal impurities have at least one type among alkaline metal, alkaline earth metal, chromium, manganese, iron, cobalt, nickel, copper, zinc, aluminum, and tin.

4.  The etching method according to claim 3, wherein the alkaline metal is at least one type among lithium, sodium, and potassium, and the alkaline earth metal is at least one type of magnesium and calcium.

5.  The etching method according to any one of claims 1 to 4, wherein a concentration of each of all types of the contained metals is 1 ppb by mass or more.

6.  The etching method according to any one of claims 1 to 5, wherein the etching compound is at least one type among a compound having a fluorine atom in a molecule and not having a hydrogen atom and an oxygen atom in the molecule, a compound having a hydrogen atom in a molecule and not having a fluorine atom and an oxygen atom in the molecule, a compound having an oxygen atom in a molecule and not having a fluorine atom and a hydrogen atom in the molecule, a compound having a fluorine atom and a hydrogen atom in a molecule and not having an oxygen atom in the molecule, a compound having a fluorine atom and an oxygen atom in a molecule and not having a hydrogen atom in the molecule, and a compound having a hydrogen atom and an oxygen atom in a molecule and not having a fluorine atom in the molecule.

7.  The etching method according to claim 6, wherein the compound having a fluorine atom in the molecule and not having a hydrogen atom and an oxygen atom in the molecule is at least one type among sulfur hexafluoride, nitrogen trifluoride, chlorine trifluoride, iodine heptafluoride, bromine pentafluoride, phosphorus trifluoride, trifluoroiodomethane, fluorine gas, chain saturated perfluorocarbons having 1 or more and 3 or less carbon atoms, unsaturated perfluorocarbons having 2 or more and 6 or less carbon atoms, cyclic perfluorocarbons having 3 or more and 6 or less carbon atoms, and halons having 1 or more and 3 or less carbon atoms.

8.  The etching method according to claim 6, wherein the compound having a hydrogen atom in the molecule and not having a fluorine atom and an oxygen atom in the molecule is at least one type among bromomethane, dibromomethane, hydrogen gas, hydrogen sulfide, hydrogen chloride, hydrogen bromide, ammonia, alkanes having 1 or more and 3 or less carbon atoms, alkenes having 2 or more and 4 or less carbon atoms, and cyclic alkanes having 3 or more and 6 or less carbon atoms.

9.  The etching method according to claim 6, wherein the compound having an oxygen atom in the molecule and not having a fluorine atom and a hydrogen atom in the molecule is at least one type among oxygen gas, carbon monoxide, carbon dioxide, carbonyl sulfide, and sulfur dioxide.

10. The etching method according to claim 6, wherein the compound having a fluorine atom and a hydrogen atom in the molecule and not have an oxygen atom in the molecule is at least one type among chain saturated hydrofluorocarbons having 1 or more and 4 or less carbon atoms, unsaturated hydrofluorocarbons having 2 or more and 6 or less carbon atoms, and cyclic hydrofluorocarbons having 3 or more and 6 or less carbon atoms, and hydrogen fluoride.

11. The etching method according to claim 6, wherein the compound having a fluorine atom and an oxygen atom in the molecule and not having a hydrogen atom in the molecule is at least one type among carbonyl fluoride, oxygen difluoride, trifluoromethyl hypofluoride, perfluoroethers having 2 or more and 4 or less carbon atoms, and perfluoroketones having 3 or more and 5 or less carbon atoms.

12. The etching method according to claim 6, wherein the compound having a hydrogen atom and an oxygen atom in the molecule and not having a fluorine atom in the molecule is at least one type among water, alcohols having 1 or more and 3 or less carbon atoms, ethers having 2 or more and 4 or less carbon atoms, and ketones having 3 or more and 5 or less carbon atoms.

FIG. 1

## INTERNATIONAL SEARCH REPORT

| International application No. |
| --- |
| **PCT/JP2022/045918** |

| A. | CLASSIFICATION OF SUBJECT MATTER |
| --- | --- |

*H01L 21/3065*(2006.01)i
FI:   H01L21/302 105A

According to International Patent Classification (IPC) or to both national classification and IPC

| B. | FIELDS SEARCHED |
| --- | --- |

Minimum documentation searched (classification system followed by classification symbols)

H01L21/3065

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2016-197713 A (CENTRAL GLASS COMPANY, LIMITED) 24 November 2016 (2016-11-24)<br>    paragraphs [0014]-[0043] | 1-12 |
| A | JP 2017-092357 A (CENTRAL GLASS COMPANY, LIMITED) 25 May 2017 (2017-05-25) | 1-12 |
| A | JP 2017-141149 A (CENTRAL GLASS COMPANY, LIMITED) 17 August 2017 (2017-08-17) | 1-12 |
| A | JP 2007-302663 A (ULSAN CHEMICAL CO LTD) 22 November 2007 (2007-11-22) | 1-12 |
| A | JP 2019-502253 A (L'AIR LIQUIDE, SOCIETE ANONYME POUR L'ETUDE ET L'EXPLOITATION DES PROCEDES GEORGES CLAUDE) 24 January 2019 (2019-01-24) | 1-12 |

☐ Further documents are listed in the continuation of Box C.        ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **11 January 2023** | **24 January 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**EP 4 481 794 A1**

**INTERNATIONAL SEARCH REPORT**
Information on patent family members

International application No.

**PCT/JP2022/045918**

| Patent document cited in search report | | | Publication date (day/month/year) | Patent family member(s) | | | Publication date (day/month/year) |
|---|---|---|---|---|---|---|---|
| JP | 2016-197713 | A | 24 November 2016 | US | 2018/0066187 | A1 | |
| | | | | paragraphs [0029]-[0063] | | | |
| | | | | WO | 2016/163184 | A1 | |
| | | | | TW | 201700443 | A | |
| | | | | KR | 10-2017-0121233 | A | |
| | | | | CN | 107533969 | A | |
| JP | 2017-092357 | A | 25 May 2017 | (Family: none) | | | |
| JP | 2017-141149 | A | 17 August 2017 | US | 2019/0047858 | A1 | |
| | | | | WO | 2017/138367 | A1 | |
| | | | | TW | 201731762 | A | |
| | | | | KR | 10-2018-0113208 | A | |
| JP | 2007-302663 | A | 22 November 2007 | US | 2007/0265478 | A1 | |
| | | | | DE | 102006049156 | A1 | |
| | | | | KR | 10-2007-0108987 | A | |
| | | | | TW | 200742741 | A | |
| JP | 2019-502253 | A | 24 January 2019 | US | 2018/0327913 | A1 | |
| | | | | WO | 2016/172740 | A2 | |
| | | | | EP | 3375008 | A2 | |
| | | | | TW | 201718942 | A | |
| | | | | KR | 10-2018-0067667 | A | |
| | | | | CN | 108352316 | A | |

Form PCT/ISA/210 (patent family annex) (January 2015)

## EP 4 481 794 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019153771 A